# EUROPEAN PATENT APPLICATION

(11) **EP 2 645 466 A1**
(43) Date of publication of application: **02.10.2013**
(21) Application number: 13156491.6
(22) Date of filing: 25.02.2013
(51) Int. Cl.: H01M 10/42

(54) **Battery system**

(30) Priority: 29.03.2012 JP 2012075390
(71) Applicant: Hitachi Ltd., Tokyo 100-8280 (JP)
(72) Inventor: Takahashi, Toshiki, Tokyo, 100-8220 (JP); Sakabe, Kei, Tokyo, 100-8220 (JP)
(74) Representative: MERH-IP Matias Erny Reichl Hoffmann

(57) **Abstract**

Provided is a battery system including battery modules each having a plurality of batteries 20 and a battery module control unit 31 for controlling the plurality of batteries 20, and battery pack control units 230 for controlling a plurality of the battery module control units 31, wherein the plurality of the battery module control units 31 are connected in serial by wires between modules, wherein each battery module control unit 31 includes a first input/output terminal for inputting or outputting information to or from a battery module control unit 31 of one adjacent battery module 30 and a second input/output terminal for inputting or outputting information to or from a battery module control unit 31 of another adjacent battery module 30, and wherein an input impedance of the first input/output terminal is smaller than an input impedance of the second input/output terminal.

## Description

### BACKGROUND OF THE INVENTION

### 1. Field of the Invention

The present invention relates to a battery system having a control controller installed therein.

### 2. Description of the Related Art

Battery systems, the development of which has been progressing in recent years, can be applied in many ways, and the size of each battery system varies in accordance with the purpose of usage. Especially, battery systems which are used for load variation control and power outage solutions of a server center, stabilizing a large scale system such as a regenerative power absorption system of a railroad, a renewable energy system, and a nuclear power plant, are large.

In the case where the battery system has a plurality of battery modules, in order to communicate with or control the plurality of battery modules, it has been considered to perform one on one communication between an upper electrical potential and a lower electrical potential by connecting the battery module control units respectively provided in each of the battery modules in a daisy chain manner, and perform communication by means of a bus connection in the parallel direction. In this case, it is necessary to prepare a battery system in which two termination resistors are provided between each of the battery modules, and a termination resistor is mounted in the beginning part and the termination part of the bus connection. According to such a configuration, the number of parts increases in a large-scale battery system.

JP-A-10-105305 discloses a battery system including a selector circuit which uses an external connector for selecting whether to mount a termination resistor, thereby reducing the number of the termination resistors.

### SUMMARY OF INVENTION

However, in a method of mounting a termination resistor relating to the conventional technology, it is necessary to add a mounting selection circuit, thus it is not possible to solve the problem that the number of parts increases. In addition, setting operation of mounting selection accompanies addition of the mounting selection circuit, thus communication delays and the like occur.

Consequently, considering the above problem, the object of the present invention is to provide a battery system in which communication delays do not occur while reducing the number of parts of the termination resistor.

According to an aspect of the invention, there is provided a battery system including a battery module having a plurality of batteries and a battery module control unit for controlling the plurality of batteries, and a battery pack control unit for controlling a plurality of the battery module control units, wherein the plurality of battery module control units are connected in serial by a wire between modules, wherein each battery module control unit includes a first input/output terminal for inputting or outputting information to or from a battery module control unit of an adjacent battery module and a second input/output terminal for inputting or outputting information to or from a battery module control unit of an adjacent battery module, and wherein an input impedance of the first input/output terminal is smaller than an input impedance of the second input/output terminal.

According to the aspect of the invention, it is possible to provide a battery system capable of restricting communication delays while reducing the number of parts of the termination resistors.

### BRIEF DESCRIPTION OF THE DRAWINGS

Fig. 1 is a view illustrating a power generation system according to the present invention.
Fig. 2 is a block diagram of a battery system according to the present invention.
Fig. 3 is a circuit diagram of a battery module according to the present invention.
Fig. 4 is a circuit diagram of a battery pack according to the present invention.
Fig. 5 is a circuit diagram of a battery system according to the present invention.
Fig. 6 is an outline diagram of the battery pack according to the present invention.

### DETAILED DESCRIPTION OF THE PREFERRED EMBODIMENTS

### (First Embodiment)

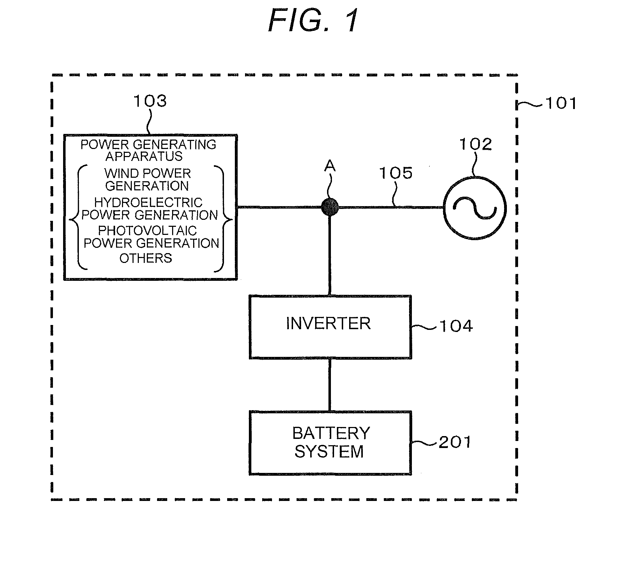

Hereinafter, it will be described about an embodiment of the present invention with reference to the accompanying drawings. First, a power generation system 101 relating to the present invention will be described using Fig. 1. The power generation system 101 includes a power generating apparatus 103, a power system 102, an electric wire 105 to connect the power system 102 with the power generating apparatus 103, a battery system 201 connected to the electric wire 105 through an inverter 104. Examples of the power generating apparatus 103 include wind power generation equipment, hydroelectric power generation equipment, and photovoltaic power generation equipment, or other generation equipment.

If the power generating apparatus 103 generates power in excess of the power requested in the power system 102, the battery system 201 charges with the excessively generated power, on the contrary, if the power generating apparatus 103 generates less power than the power requested in the power system 102, the battery system 201 discharges the charged power, thereby aiming to stably supply power. Also, in the case where the battery system 201 performs charging or discharging, reception or supply of power is performed while an AC to DC conversion or a DC to AC conversion is performed by the inverter 104.

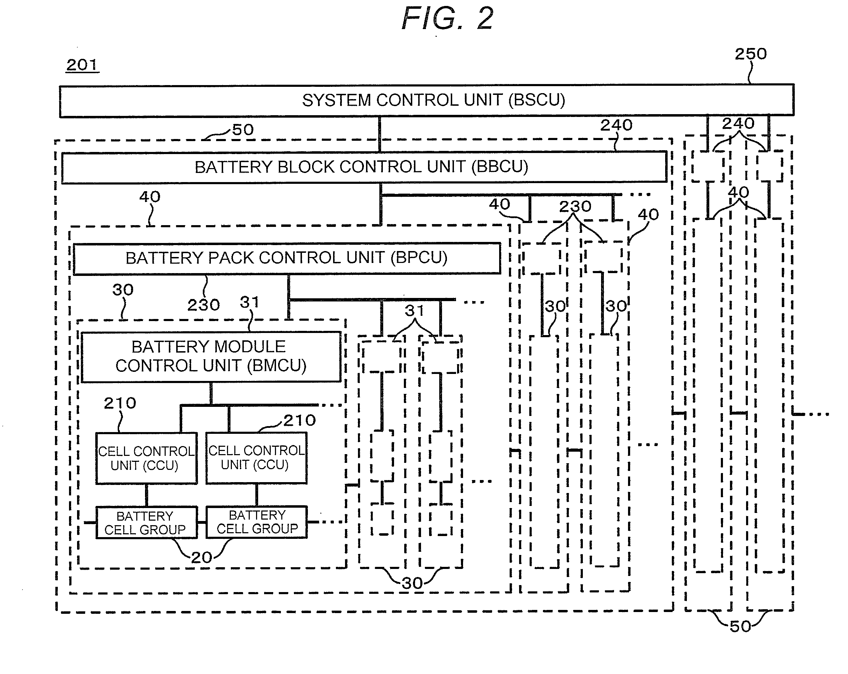

Subsequently, a block diagram of the battery system 201 is shown in Fig. 2. The battery system 201 according to the present invention includes battery blocks 50 having a plurality of battery packs 40, the battery packs 40 having a plurality of battery modules 30, using a battery module 30 as a minimum unit.

The specific explanation of the configuration of the battery module 30 will be given. The battery module 30 includes a plurality of battery cell groups 20, cell control units (CCU) 210 to collect battery information of the battery cell groups 20 (for example, current information, voltage information, temperature information, charging state, and the like of the battery cell) and a battery module control unit (BMCU) 31. In addition, the cell control unit 210 performs balancing control between the battery cells described below. The battery information collected in the cell control unit 210 is sent to the battery module control unit (BMCU) 31. Also, in the battery module control unit (BMCU) 31, average charging state of the battery cell groups 20 inside the battery module 30 is calculated and battery information of average charging state of the battery cell groups 20 is added to the above battery information to supply an upper battery pack control unit (BPCU) 230 with battery information.

The battery pack 40 has the plurality of battery modules 30 and a battery pack control unit 230. The battery pack control unit 230 collects battery information output from each battery module control unit 31 to calculate information about average charging state of the battery module 30 obtained by taking an average of the charging states of the battery modules 30 inside the battery pack 40. By adding the information about average charging state of the plurality of battery modules 30 to battery information obtained from the battery module control units 31, the battery information is output to an upper battery block control unit 240.

The battery block 50 has a plurality of battery packs 40 and a battery block control unit 240. The battery block control unit 240 collects battery information output from each battery pack control unit 230 to calculate information about average charging state of the battery pack 40 obtained by taking an average of the charging state of the battery pack 40 inside the battery block 50. By adding the information about average charging state of the plurality of battery packs 40 to battery information obtained from the battery pack control unit 230, the battery information is output to an upper system control unit 250. Though the description states that the battery block 50 has a plurality of battery packs 40, the number of the battery packs 40 constituting the battery block 50 may be one. In that case, the battery block control unit 240 outputs the battery information as it is output from the battery pack control unit 230 to the system control unit 250.

In the present invention, since the state of the battery is monitored in the plurality of layers, the battery system 201 has high safety performance. Since each of the battery module 30, the battery pack 40 and the battery block 50 according to the present invention can be replaced in each unit, the battery system has good maintainability.

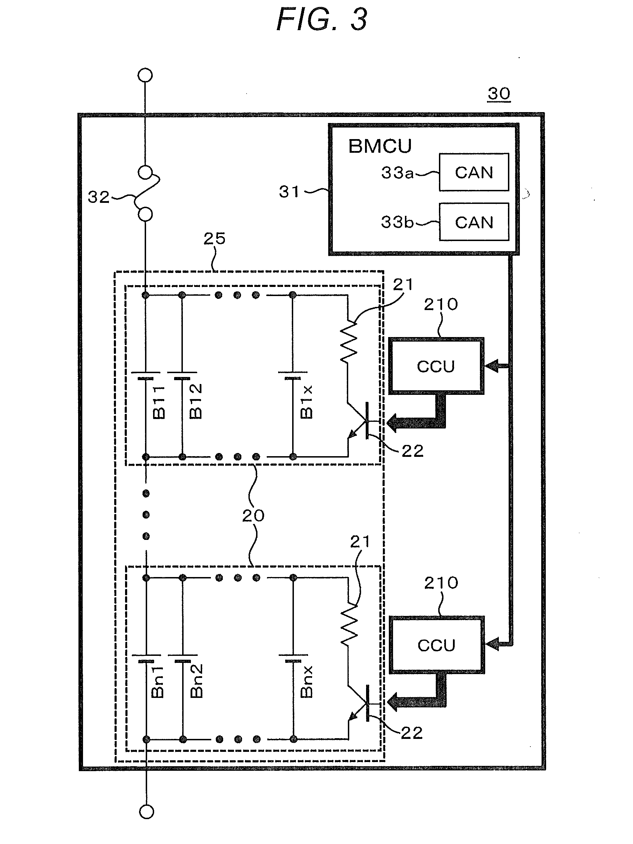

Subsequently, it will be specifically described about the circuit configuration of the battery module 30 using Fig. 3. The battery module 30 includes a power source circuit 25 connected in serial with the plurality of battery cell groups 20 and a fuse 32 connected in serial with the power source circuit provided therein. The battery cell group 20 has a configuration in which a plurality of battery cells Bn1, Bn2 ... BnX are connected in parallel (where, n is a number greater than 1, indicating the number of battery cell groups 20 connected in serial. X is the number of the cells). Also, a resistor element 21 and a switch element 22 are connected in parallel with the battery cell group 20. The resistor element 21 and the switch element 22 are for performing balancing between battery cells B11, B12 ... B1X when there is variation in voltages between or charging states of, for example, the battery cells B11, B12 ... B1X.

The cell control unit 210 obtains battery information of each of the battery cells Bn1, Bn2 ... BnX to output the obtained information to the battery module control unit 31. The battery module control unit 31 calculates the state of charging (SOC) of each battery cell based on the battery information output from each cell control unit 210 to output charging state information to the cell control unit 210. When differences among the charging states of the battery cells Bn1, Bn2 ... BnX inside the battery cell group 20 that the cell control unit 210 monitors become 10% or more, the cell control unit 210 which receives the charging state information outputs a signal to make the switch element 22 ON state to perform balancing between the battery cells Bn1, Bn2 ... BnX.

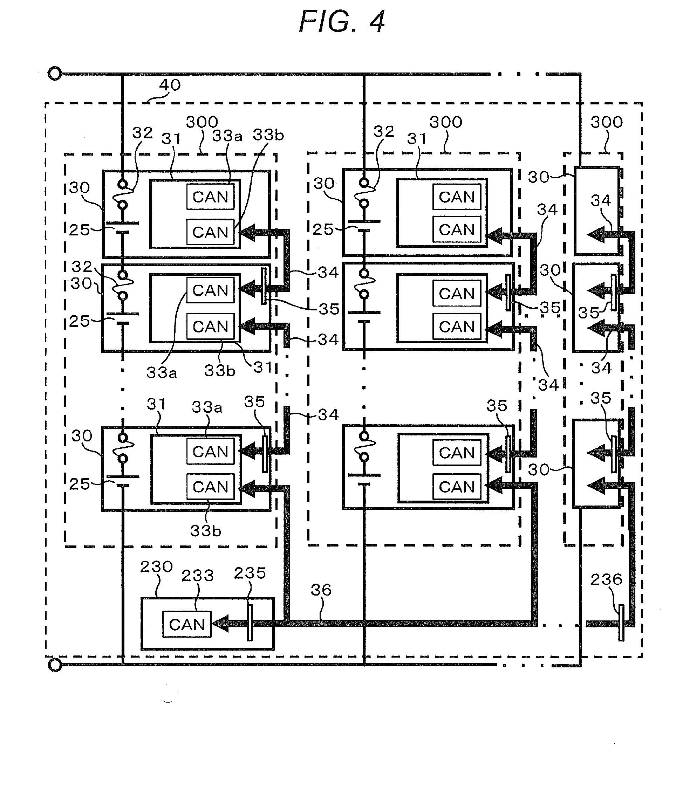

In addition, in the aforementioned battery module control unit 31, there are a CAN communication connecting portion 33a and 33b. The battery module control unit 31 is connected to other battery module control unit 31 through CAN communication connecting portion 33a and 33b, however, the detailed description thereof will be given using Fig. 4.

Fig. 4 shows a circuit diagram of the battery pack 40. The battery pack 40 is configured such that a plurality of module serial bodies 300 to which the plurality of battery modules 30 are connected in serial, are connected in parallel, and each of the plurality of module serial bodies 300 connected in parallel is communicated and controlled by one battery pack control unit 230.

Subsequently, it will be described about connection between the battery pack control unit 230 and the battery module control unit 31 of each of the battery modules 30 constituting the module serial body 300. The battery pack control unit 230 and the battery module control units 31 are connected by a connection wire 36. In addition, a termination resistor 235 is provided in the battery pack control unit 230. Also, a termination resistor 236 is provided in the end of the connection wire 36. Though the resistance is determined by a transceiver used in CAN communication in the present invention, the resistance value of the termination resistor 235 may be 60 Ω. The resistance value of the termination resistor 236 may also be 60 Ω. The resistance values are set to the values, thereby restricting noise due to signal reflection in the case of performing CAN communication. On the other hand, in the case where a pattern which makes impedance asymmetric is considered, the termination resistor may be configured such that the resistance value of the combined resistance becomes 60 Ω.

The battery module control unit 31 has two CAN communication connecting portions 33a and 33b as described above, the two CAN communication connecting portions 33a and 33b are connected to each other by connection wires 34 in a daisy chain configuration (a configuration of serial connection). Each of the CAN communication connecting portions 33b of the battery module control units 31 connected to the battery pack control unit 230, an upper controller, is connected to the CAN communication connecting portion 233 of the battery pack control unit 230 by the connection wire 36 in a bus configuration.

Subsequently, it will be described about the parts connected in a daisy chain configuration. The CAN communication connecting portion 33a provided in one battery module control unit 31 and the CAN communication connecting portion 33b provided in the battery module control unit 31 of adj acent battery module 30 are connected by the connection wire 34 through the termination resistor 35, thus communication between battery module control units 31 is performed. The termination resistor 35 is provided in the battery module 30, specifically, only in one side of the CAN communication connecting portion 33 of each battery module control unit 31. In other words, the input impedance on the CAN communication connecting portion 33a side is configured to be different from the input impedance on the CAN communication connecting portion 33b side, and the input impedance on the one side (the CAN communication connecting portion 33b side) is low.

In this case, the resistance value of the termination resistor 35 is determined such that the resistance value of the termination resistor 35 has 1/2 value of the resistance value at the time when the termination resistors are attached to the both ends of the CAN communication connecting portions 33a and 33b (the combined resistance when the termination resistor of 120 Ω is connected in parallel). That is, if the resistance value of the termination resistor 35 is set to 60 Ω, it is possible to sufficiently restrict the signal reflection.

In the case of connection in the daisy chain configuration, if the path of reflected signal reaches 1/4 of the wavelength of the signal, it becomes a problem, but 1/50 of the wavelength of the signal is also considered in order to enhance reliability. In addition, in the case of digital communication (communication in a rectangular wave), many harmonics are included, thus it is necessary to consider the wavelength of the harmonics, especially, to reduce an influence of a fifth harmonic of a signal. For example, in the case of performing CAN communication (1MHz is an upper limit), the length of 1/50 of a fifth harmonic is 1.2 m. Consequently, the length of the connection wire 34 is set to 1.2 m or less, thereby sufficiently suppressing signal reflection using the aforementioned termination resistor.

In the above configuration, it is not necessary to select whether to mount the termination resistor, thereby providing a mounting method of a termination resistor in which it is not necessary to perform a setting operation for selecting mounting and add a circuit for selecting mounting. Also, in the present invention, it is possible to restrict the increase in the number of the termination resistor due to increase of the termination in the case of realizing a configuration having a daisy chain connection and a bus connection in the same circuit board (for example, herein referred to as the battery module control unit 31).

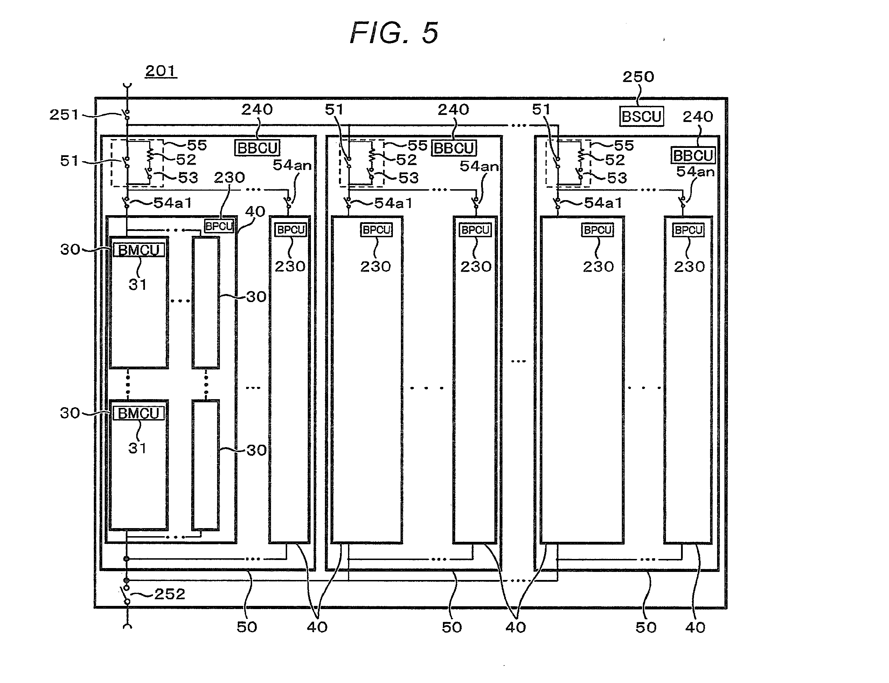

Subsequently, it will be described about a circuit configuration of the battery system 201 using Fig. 5. Fig. 5 is a diagram showing the battery system 201 to which the plurality of the battery blocks 50 having the battery packs 40 including the plurality of battery modules 30 are connected in parallel.

First, it will be described about the configuration of the battery block 50. The battery block 50 includes the battery pack 40, a pre-charging circuit 55 connected in serial with the battery pack 40. In addition, the battery blocks 50 are connected in parallel each other, connected to a positive electrode side of the inverter 104 through a switch body 251 and connected to a negative electrode side of the inverter 104 through a switch body 252.

A pre-charging circuit 55 includes a switch element 51, and a resistor element 52 and a switch element 53 which are connected in parallel with the switch element 51. When there is a variation in the charging states or voltages among the battery blocks 50, the pre-charging circuit 55 turns a switch body 251 and a switch body 252 off in order to keep for the time being the duration when the switch element 51 is turned off and the switch element 53 is turned on, thereby lowering a variation in the charging states or voltages among the battery blocks 50 using cross current.

Also, the battery block 50 has switch elements 54a1 (54a), 54a2 (54a) ... 54an(54a) (where n is the number of battery packs 40 connected in parallel inside the battery block 50) connected in serial corresponding to the battery pack 40. When there is a problem in each battery pack 40, the switch element 54a, corresponding to the battery pack 40 having the problem, is made open, and thus the switch element 54a may be separated from other battery pack 40.

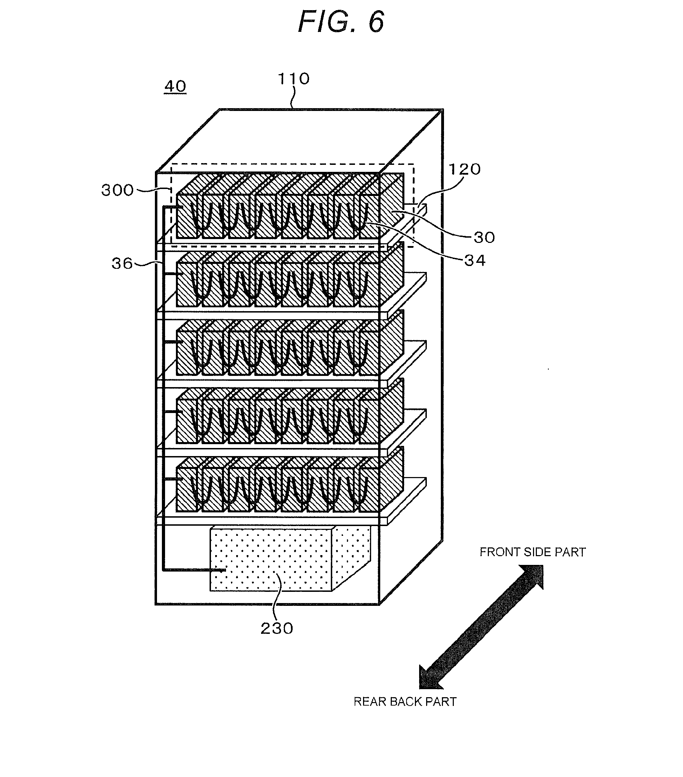

Subsequently, the outline diagram of the battery pack 40 relating to the present invention is shown in Fig. 6. Fig. 6 is a diagram viewing the battery pack 40 from the back. The battery pack 40 includes the plurality of battery modules 30, the battery pack control unit 230 to control the plurality of battery modules 30, a module mounting plate 120 on which the plurality of battery modules 30 are mounted and a battery rack 110. The battery modules 30 are mounted and arranged on the module mounting plate 120 to construct the module serial body 300. In addition, the battery modules 30 are disposed separately each other in Fig. 6, but may be disposed closely each other. In the case where the battery modules 30 are disposed closely, it is easy to discharge the heat generated in the battery module 30 and the length of the connection wire 34 which connects the battery modules 30 each other may be short. Also, the connection wire 34 has a length of 1.2 m or less as described above.

Using the above configuration, though connected in a daisy chain configuration, it is possible to sufficiently restrict signal reflection.

On the other hand, among the battery modules 30 constituting the module serial body 300, the side connected with the battery pack control unit 230 is connected through the connection wire 36 with the battery pack control unit 230 in a bus configuration.

As described above, by using the present invention, it is possible to provide the battery system capable of suppressing communication delay while lowering the number of the parts of the termination resistors.

Features, components and specific details of the structures of the above-described embodiments may be exchanged or combined to form further embodiments optimized for the respective application. As far as those modifications are apparent for an expert skilled in the art they shall be disclosed implicitly by the above description without specifying explicitly every possible combination.

## Claims

1. A battery system comprising:
battery modules (30) each having a plurality of batteries (20) and a battery module control unit (31) for controlling the plurality of batteries (20); and
battery pack control units (230) for controlling a plurality of the battery module control units (31),
wherein the plurality of battery module control units (31) are connected in serial by wires between modules,
wherein each battery module control unit (31) includes a first input/output terminal for inputting or outputting information to or from a battery module control unit (31) of one adjacent battery module (30) and a second input/output terminal for inputting or outputting information to or from a battery module control unit of another adjacent battery module (30), and
wherein an input impedance of the first input/output terminal is smaller than an input impedance of the second input/output terminal.

2. The battery system according to claim 1,
wherein a resistor element is provided on the first input/output terminal side and a resistor element is not provided on the second input/output terminal side.

3. The battery system according to claim 2,
wherein a resistance value of the resistor element is 60 Q.

4. The battery system according to any one of claims 1 to 3,
wherein a plurality of battery module (30) groups are connected in parallel, in which the plurality of battery module control units (31) are connected each other by wires between modules, and
wherein one battery module control unit (31) in each battery module (30) group is connected in parallel with the battery pack control unit (230) by a wire.

5. The battery system according to claim 4,
wherein the battery pack control unit (230) is connected through a first termination resistor, and
wherein the battery module control unit (31) in any one of the battery module (30) groups is connected through a second terminal resistor.

6. The battery system according to any one of claims 1 to 5, the length of the wire between modules is 1/50 or less of the frequency of a signal to be communicated.

7. The battery system according to any one of claims 1 to 5, the length of the wire between modules is 1/50 or less of the frequency of a fifth harmonic of a signal to be communicated.

8. The battery system according to any one of claims 1 to 5, the length of the wire between modules is 1.2 m or less.
